# DEMANDE DE BREVET EUROPEEN

(11) **EP 1 020 765 A1**
(43) Date de publication de la demande: **19.07.2000**
(21) Numéro de dépôt: 00400079.0
(22) Date de dépôt: 13.01.2000
(51) Int. Cl.: G03F 7/004, B41M 5/36, B44F 1/06

(54) **Procédé d'obtention d'un motif sur un substrat en matériau verrier**

(30) Priorité: 15.01.1999 FR 9900367
(71) Demandeur: SAINT-GOBAIN VITRAGE, 92400 Courbevoie (FR)
(72) Inventeur: Demars, Yves, 60600 Agnetz (FR); Elluin, Jean-Christophe, 60750 Choisy au Bac (FR); Longchampt, Gilles, Le Plessis Brion, 60150 Thourotte (FR)
(74) Mandataire: Muller, René

(57) **Abrégé**

L'invention concerne un procédé d'obtention d'un motif sur un substrat matériau verrier.

Selon l'invention, on réalise les étapes suivantes :
a) on dépose sur au moins une zone d'une des faces du substrat une composition à base de particules minérales comportant au moins une fritte de verre et une résine thermo et/ou photosensible comportant au moins un composé photosensible essentiellement constitué d'un polymère réticulable ;
b) on chauffe et/ou on insole certaines plages de manière à faire réticuler le polymère ;
c) on dépouille les plages non chauffées et/ou non insolées ;
d) on soumet ledit substrat à au moins un cycle de traitement, notamment pour permettre la fixation desdites particules minérales.

L'invention concerne également le substrat obtenu selon ce procédé et ses applications.

## Description

La présente invention concerne un procédé d'obtention d'un motif sur un substrat en matériau verrier et le substrat obtenu selon ce procédé.

Pour obtenir un motif décoratif sur un substrat en verre ou en vitrocéramique, il est bien connu de l'état de la technique d'utiliser des émaux.

Les émaux utilisés pour cette application sont généralement obtenus à partir de ce que l'on appelle une composition d'émail comprenant une poudre constituée essentiellement d'au moins une fritte de verre (qui joue le rôle de matrice vitreuse) et de pigments en tant que colorants notamment, les pigments étant à base d'oxydes métalliques, et d'un médium permettant l'application de la composition d'émail sur le substrat et son adhésion temporaire avec celui-ci. Le médium choisi selon la destination de l'émail doit assurer une bonne mise en suspension des particules de fritte et de pigments utilisés et doit se consumer lors de la cuisson de l'émail. Ce médium peut comprendre des solvants, des diluants, des huiles, des résines...

Il est connu de déposer ces émaux par différentes techniques d'impression, tout particulièrement par des techniques de sérigraphie à l'aide d'une toile dont le maillage et l'ouverture des mailles sont fonction du motif à obtenir. Ces techniques d'impression sont très avantageuses d'un point de vue économique dans la mesure où elles permettent la fabrication en grande série à une cadence importante. En outre, elles sont très bien adaptées à la reproduction de motifs décoratifs de grandes dimensions sur des substrats de type verrier.

Cependant, ces techniques ne donnent pas entière satisfaction, notamment en termes de souplesse d'utilisation et d'esthétisme.

En effet, d'une part un changement de motif à reproduire impose nécessairement un changement d'écrans de sérigraphie, ce qui est contraignant sur le plan industriel, notamment quand on vise une production " personnalisée " en petite série.

D'autre part, la technique même de la sérigraphie laisse visible dans le motif décoratif une trame révélatrice de la toile de l'écran. Visuellement, le substrat revêtu du motif tramé a quelque peu l'aspect d'un tissu.

Il est également connu de l'art antérieur, lorsqu'une application décorative sur un support en un matériau quelconque est visée, notamment la formation d'une image visible colorée, d'utiliser des résines photosensibles comme supports de pigments ou de colorants.

Pour une telle application, il est connu de procéder de deux manières différentes pour utiliser ces résines photosensibles :
→ la première consiste à incorporer l'ingrédient désiré (pigment ou colorant) directement à la composition contenant la résine photosensible, puis à exposer celle-ci au travers d'un cliché positif ou négatif par l'intermédiaire d'une lampe à U.V. et enfin à dépouiller à l'aide d'un solvant adéquat de manière à obtenir une image insoluble qui contient ledit ingrédient sur le support.
   En outre, cette étape de dépouillement est d'une mise en oeuvre lourde et compliquée d'autant plus qu'il faut trouver une parfaite affinité entre le solvant utilisé et la résine, et maîtriser les conditions opératoires, notamment en terme de durée.
→ la deuxième consiste à exposer tout d'abord la résine photosensible de la même façon que précédemment puis à faire absorber le(s) pigment(s) directement par les parties non insolées de ladite résine et enfin de dépouiller l'ensemble à l'aide d'un solvant approprié.

Outre le fait que ces deux manières de procéder ont en commun de ne pas être adaptées aux motifs décoratifs de grandes dimensions, tout particulièrement parce qu'il est difficile d'avoir une bonne répartition des pigments sur toute la surface du support, elles présentent également l'inconvénient majeur de ne pas être des solutions durables dans le temps car les pigments ou colorants tendent à se désolidariser du support.

L'invention a alors pour but de remédier aux inconvénients précités, et notamment de proposer un nouveau procédé d'obtention d'un motif sur un substrat en matériau verrier, adaptable à la fois aux petites et aux grandes séries et qui permette d'avoir un motif particulièrement esthétique, de très haute définition et durable dans le temps sans que cela se fasse au détriment du coût de fabrication.

Pour ce faire, l'invention a pour objet un procédé d'obtention d'un motif sur un substrat en matériau verrier.

Selon l'invention, on réalise les étapes suivantes, notamment de manière successive :
a) on dépose sur au moins une zone d'une des faces du substrat une composition à base de particules minérales et une résine thermo et/ou photosensible comportant au moins un composé photosensible essentiellement constitué d'un polymère réticulable ;
b) on chauffe et/ou on insole certaines plages de manière à faire réticuler le polymère ;
c) on dépouille les plages non durcies et/ou non insolées ;
d) on soumet ledit substrat à au moins un cycle de traitement, notamment pour permettre la fixation desdites particules minérales.

Dans le cadre de l'invention, on comprend que le substrat en matériau verrier peut être transparent ou opaque et notamment en verre ou en vitrocéramique.

On comprend également par motif tout ce qui est susceptible de modifier l'apparence et/ou la structure du substrat nu éventuellement revêtu d'une ou plusieurs couche(s) mince(s), soit en lui donnant un effet particulier, soit en lui donnant l'aspect ornemental sous la forme d'une représentation, éventuellement dans un but d'identification, soit en lui donnant d'autres fonctions. Une partie de ces autres fonctions sera détaillée par la suite.

Dans le contexte de l'invention, on entend par " particules minérales ", tout élément minéral réflecteur à indice de réfraction très éloigné par rapport à celui du substrat nu.

De même, il faut comprendre que parmi " les particules minérales " qui apportent la modification de l'apparence et/ou la structure du substrat nu, au moins une partie sert de liant dont la température de fusion est inférieure à celle à laquelle on soumet le substrat.

Pour le dépôt selon l'étape a), deux variantes sont envisageables :
- il peut être réalisé sous la forme d'une unique couche de composition à base de particules minérales et la résine thermo et/ou photosensible préalablement mélangées ;
- il peut être réalisé sous la forme d'une première couche de composition à base de particules minérales revêtue d'une seconde couche de la résine thermo et/ou photosensible.

Il est possible selon la dernière variante citée de réaliser très rapidement le dépôt sur des substrats de grandes dimensions avec des installations couramment utilisées, telles que des machines à rideaux, ce qui est très avantageux à l'échelle industrielle, en particulier pour les grandes séries.

Pour ce qui est de l'étape de " fixation des particules minérales " relative à l'étape d) selon l'invention, elle peut être provisoire ou définitive en fonction du type de traitement que l'on fait subir au substrat.

Ainsi la fixation provisoire est par exemple obtenue par un traitement aux ultraviolets (UV) qui durcit les plages chauffées et/ou insolées.

Les avantages apportés par ce type de traitement sont multiples.

En effet, la manipulation du substrat devient aisée et il est alors possible de le transporter avant d'obtenir une fixation définitive des particules minérales conformes à l'invention.

De même, la fixation définitive des particules minérales peut être obtenue par un cycle de traitement thermique. C'est alors la partie précitée qui sert de liant qui fond lors de ce même cycle de traitement thermique.

Bien évidemment, comme il sera décrit ci-après une variante de l'invention peut consister en ce que toutes les particules minérales fondent lors du cycle de traitement thermique de l'étape d).

Tel est le cas par exemple d'une fritte de verre dite à bas point de fusion, c'est-à-dire à point de fusion inférieur à la température de déformation du substrat, c'est-à-dire dans la plupart des cas inférieure à 1000°C, généralement inférieur à 650°C.

Dans ce cas précis, on obtient un motif décoratif à effet sablé (la surface vitrée étant plus ou moins diffusante).

On précise tout de suite que dans le cadre de l'invention, par fritte de verre, on comprend une composition vitrifiable substantiellement transparente, sous forme de poudre à base d'oxydes métalliques sans pigment.

Une conséquence avantageuse du procédé selon l'invention est qu'il est d'une mise en oeuvre simple et peu onéreuse, les conditions opératoires ne nécessitant pas de précaution particulière, si ce n'est une bonne maîtrise de l'étape b) d'insolation et/ou de chauffage de manière à obtenir la réticulation du polymère.

Subsidiairement, le procédé selon l'invention permet la " personnalisation " a sou hait du motif décoratif sans que cela ne nécessite la préparation longue et minutieuse d'un (d') outillage(s) spécifique(s), avantage non négligeable sur le plan industriel.

Lorsqu'on l'utilise conjointement au polymère tel que défini ci-dessus, son intervalle de sensibilité s'étend jusqu'à une longueur d'onde égale à environ 0,5 micron c'est-à-dire au-delà du domaine des ultraviolets (dont la limite supérieure est égale à 0,38 µm). On s'affranchit ainsi du choix d'une source de rayonnement très spécifique pour réaliser l'étape b).

Avantageusement, le polymère réticulable qui s'est révélé être le plus approprié est fabriqué à partir d'acrylate et de dipropylène glycol diacrylate.

Avantageusement encore, la résine photosensible conforme à l'invention comporte au moins un agent sensibilisateur, de préférence moins de 10 % en poids.

De préférence, l'agent sensibilisateur choisi est un dérivé du benzothiazole ou du naphtothiazole ou éventuellement dans le but d'étendre la sensibilité spectrale, un sel d'anilinovinyl-hétérocycloammonium. De préférence encore, ledit agent sensibilisateur est le 1-N(méthylbenzothiazolylidène) dithioacétate de méthyle.

Une telle proportion permet d'adapter au mieux la vitesse de déplacement du substrat et/ou de la source de rayonnement par rapport à la puissance d'insolation requise par l'application visée.

Ainsi, par exemple, pour une puissance spécifique d'insolation requise de l'ordre de 80 W/cm², la vitesse de déplacement de la source de rayonnement pourra être choisie comprise entre 4 et 60 m/mn.

Pour réaliser l'étape b) du procédé selon l'invention, lorsque la résine utilisée est exclusivement photosensible, trois variantes sont envisageables :
- selon la première variante, l'insolation est faite à l'aide d'une source de rayonnement, notamment ultraviolet, éclairant toute la surface d'un cliché reproduisant le motif décoratif,
- selon la deuxième variante, l'insolation est faite par projection d'une image,
- selon la troisième variante préférée, l'insolation est faite à l'aide d'une source de rayonnement ponctuelle, notamment ultraviolet, de préférence un laser, dont le faisceau balaie certaines plages.

Cette troisième variante préférée permet d'avoir des dégradés très prononcés à des endroits du motif très localisés puisque l'insolation se fait point par point. De plus, il est possible de " guider " le laser au moyen d'une unité logique programmée en fonction du motif décoratif à obtenir, ce qui confère une souplesse d'utilisation lorsque le procédé selon l'invention est mis en oeuvre sur ligne industrielle.

Selon une caractéristique très avantageuse, le choix de la granulométrie moyenne des particules minérales est tel que leur diamètre est au plus égal à la dimension des points élémentaires à insoler, de préférence inférieur au dixième.

Pour cela, on réalise un broyage très fin des particules minérales, broyage d'autant plus fin que l'on cherche à avoir un contraste important entre les différentes parties du motif décoratif et/ou une résolution du motif importante. Ainsi, un diamètre des particules d₉₀ inférieur ou égal à 10 µm, de préférence inférieur à 5 µm est particulièrement préféré.

De même, le diamètre des particules d₁₀ est de préférence choisi entre 0,2 µm et 1 µm et, de préférence encore, le diamètre d₅₀ est compris entre 1 µm et 4 µm. On rappelle que ces termes " d₉₀ ", " d₅₀ " et " d₁₀ " signifient que respectivement 90 %, 50 % et 10 % des particules minérales en question ont un diamètre inférieur à la valeur indiquée. La valeur d₉₀ donne une idée claire de la taille des particules. Combinée avec les valeurs de d₁₀ et/ou d₅₀, elle précise de manière complète la distribution des tailles de particules dans une gamme donnée de valeurs de diamètre.

Pour ce qui est de l'étape d), on soumet le substrat, de préférence, à un cycle de traitement thermique des particules minérales, à des températures supérieures ou égales aux températures de fusion de ces particules notamment comprises entre 300 et 950°C, de préférence encore aux alentours de 620°C.

De toute manière, la résine photosensible doit s'éliminer à des températures inférieures à celles nécessaires pour réaliser la fusion des particules minérales.

Avantageusement, le cycle de traitement thermique précité fait partie d'un cycle de traitement thermique de trempe, de recuit ou de bombage.

On profite ainsi de la température de fixation des particules minérales pour conférer une résistance mécanique particulière au substrat en verre. Préalablement à ce cycle de traitement thermique de fixation des particules, on peut soumettre le substrat à un premier cycle de traitement thermique de manière à brûler la résine photosensible.

Ce premier cycle de traitement thermique est particulièrement avantageux car il permet d'éviter absolument tout phénomène de " cloquage " de la résine. On s'assure ainsi que l'intégrité, et en particulier les contours des motifs, est conservée après les traitements thermiques.

De manière avantageuse, on effectue ce traitement thermique secondaire à une température de l'ordre de 430°C, pendant un temps d'environ 60 minutes par µm d'épaisseur de ladite première couche. En fonction du type de modification d'apparence et/ou de structure que l'on veut apporter au substrat nu, la composition à base de particules minérales peut comprendre une poudre métallique et/ou une poudre céramique et/ou une poudre à base d'oxydes métalliques et/ou de particules fonctionnelles du type pigments phosphorescents ou luminescents.

De manière connue, la fritte de verre contient des oxydes formateurs pour former les constituants essentiels de la matière vitreuse, des oxydes modificateurs aptes à modifier cette matrice vitreuse et capables d'influer sur le point de fusion et des oxydes intermédiaires qui, selon leur environnement et leurs proportions jouent le rôle d'oxyde formateur et/ou d'oxydes modificateurs.

L'homme de l'art, en fonction d'une part de la quantité d'oxydes modificateurs, d'autre part des rapports entre oxydes intermédiaires et oxydes formateurs choisira la composition ayant les caractéristiques de température adaptées à l'invention.

Selon une caractéristique avantageuse de l'invention, la fritte de verre comprend, en proportions pondérales, les éléments suivants :

| | |
|---|---|
| PbO | 40 - 75 % |
| ZnO | 0 - 7 % |
| Al₂O₃ | 0 - 5 % |
| SiO₂ | 1 - 35 % |
| ZrO₂ | 1 - 5 % |
| B₂O₃ | 0 - 10 % |
| K₂O | 0 - 0,2 % |
| BaO | 0 - 0,2 % |
| SrO | 0 - 0,2 % |

Selon une variante préférée de l'invention et lorsqu'on désire obtenir un motif décoratif formé d'une image visible, on ajoute à la composition à base de particules minérales préalablement à son dépôt, des pigments, de préférence d'une seule teinte.

Dans cette configuration préférée on fait jouer à l'émail d'une manière judicieuse, le rôle de liant. En effet, l'émail crée une matrice vitreuse idéale pour solidariser les pigments au support en verre de façon durable dans le temps.

Selon l'invention, il est préférable d'ajouter des pigments dans des proportions telles que le rapport en poids entre la fritte de verre et les pigments soit compris entre 50/50 et 90/10 de préférence entre 70/30 et 60/40 pour 100 parties de mélange fritte et pigments.

Pour avoir la meilleure homogénéité possible entre les pigments et la fritte de verre, on choisit avantageusement une granulométrie des pigments sensiblement égale à celle des particules de la fritte de verre. De manière préférée, le diamètre des pigments est inférieur à 10 µm, notamment compris entre 1 et 5 µm.

Lorsque l'on désire obtenir un aspect métallisé du motif décoratif, il est préférable d'avoir majoritairement des pigments de mica.

Lorsqu'on souhaite obtenir une image en polychrome de très haute définition, on réalise selon l'invention, n fois successivement les étapes a) b) c) sur la même zone en déposant la même résine, les n compositions étant remarquables en ce que chacune d'entre elles comporte majoritairement des pigments de noir ou de blanc ou conférant une seule couleur.

Selon cette variante, lorsqu'on souhaite obtenir une image en quadrichromie (n = 4), les quatre compositions comportent majoritairement ensemble des pigments de noir ou blanc et conférant les trois couleurs fondamentales, chacune d'entre elles comportant majoritairement des pigments de noir ou blanc conférant une seule des trois couleurs fondamentales.

En ce qui concerne la formulation des pigments, on choisit de préférence l'oxyde de titane TiO₂ comme pigment de blanc.

De même, pour des pigments conférant la couleur fondamentale bleue (cyan), on choisit avantageusement des pigments de Co₃O₄. Enfin, pour des pigments conférant la couleur fondamentale rouge (magenta) et jaune, on choisit de préférence des pigments d'oxyde de cadmium CdO mélangés à des pigments de sulfo-sélénure de cadmium dont on module les proportions relatives pour obtenir l'une (rouge) ou l'autre (jaune) des couleurs fondamentales.

Le motif décoratif obtenu selon l'invention peut être une image visible monochrome ou polychrome, notamment quadrichrome, et lorsque tel est le cas, la résolution de l'image est conforme à ce qui précède. Une telle finesse autorise la vision de l'image à plusieurs distances, ce qui se traduit par le fait que deux observateurs situés à une distance différente du substrat distingueront des détails de l'image différents.

L'invention est applicable à la fabrication de tout vitrage décoratif à haute résolution tel qu'une enseigne lumineuse vitrée, une porte de four vitrée avec un bandeau de cuisinière, une vitrine, cloison interne, un vitrail. On peut également associer en le feuilletant le vitrage selon l'invention avec un autre vitrage de manière à lui conférer des propriétés particulières. Cet autre vitrage peut par exemple être un substrat transparent revêtu de couches minces lui apportant une fonctionnalité bien spécifique telle qu'une fonction antireflet, anti-buée, anti-salissure.

Selon une variante préférée de l'invention, la composition à base de particules minérales comprend de la pâte d'argent.

L'invention est également applicable à la fabrication de " faces avant " d'écrans émissifs du type écrans plats tels que des écrans plasma.

En effet, un écran plasma est constitué de deux substrats de verre superposés l'un sur l'autre, constituant les faces avant et arrière de l'écran.

Si la technique de sérigraphie est tout à fait convenable en termes de précision pour déposer les éléments de la " face arrière " et plus particulièrement les luminophores et les électrodes à base de pâte d'argent, elle n'est pas nécessairement suffisante pour déposer les éléments de la face avant du fait même que ces derniers doivent être quasi parfaitement en regard d'éléments semblables de la face arrière.

La haute résolution fournie par le procédé de l'invention précité est, quant à elle, parfaitement adaptée.

Par exemple, il est possible de déposer, au regard de chaque luminophore de la face arrière, et à partir d'une poudre céramique éventuellement mélangée à une fritte de verre à bas point de fusion à l'aide de la technique selon l'invention, un filtre coloré sélectif de la longueur d'onde désirée.

Il est également possible de procéder au dépôt des électrodes à base de pâte d'argent auxquelles on demande d'être parfaitement perpendiculaires à celles de la face arrière.

Enfin, en vue d'améliorer le rendement lumineux de l'écran plasma, on peut tout aussi bien déposer des luminophores qu'il était jusqu'ici difficile de déposer en couches très fines sur la face avant.

D'autres détails et caractéristiques avantageuses ressortent ci-après de l'exemple suivant, non limitatif, conforme à l'invention.

On prépare en lumière inactinique une solution contenant un composé photosensible.

Le composé photosensible est constitué de 50 % d'acrylates et de 50 % de dipropylène glycol diacrylate.

On ajoute à ce composé photosensible un agent photoinitiateur aux U.V. dans des proportions pondérales inférieures à 5 %.

La résine ainsi formée présente une viscosité correspondant à un temps d'écoulement de l'ordre de 24 s, temps déterminé au moyen d'une coupe d'écoulement conforme à la norme ISO 2431-1984.

La résine est alors mélangée à une composition d'émail dans une proportion telle que le rapport en poids entre résine photosensible et émail est égal à 50/50 pour 100 parties du mélange résine photosensible et composition d'émail.

Pour réaliser cette composition d'émail, on effectue tout d'abord un rebroyage par voie liquide d'une fritte de verre à base de calcin d'un verre silico-sodo-calcique clair de manière à obtenir des particules très fines.

La granulométrie des particules de la fritte de verre a été mesurée : les diamètres d₁₀, d₅₀, d₉₀ ont respectivement une valeur de 0,2 µm, 1,25 µm et 10 µm.

Puis, on mélange à ces particules finement broyées des pigments d'oxyde de titane TiO₂ dont les diamètres d₁₀, d₅₀, d₉₀ ont respectivement une valeur de 0,4 µm, 2 µm, 7 µm dans une proportion telle que le rapport en poids entre pigments et fritte de verre est égal à 30/70 pour 100 parties du mélange fritte et pigments.

La composition de l'émail est en proportions pondérales la suivante : 42 % de PbO, 4,9 % de ZnO, 1,9 % de SiO₂, 1,4 % de ZrO₂, 0,9 % d'Al₂O₃, 0,14 % de SrO et 48 % de TiO₂.

Enfin, on mélange l'ensemble fritte de verre plus pigments ainsi constitué à un médium qui est de l'alcool.

Une fois le mélange entre résine photosensible et composition d'émail effectué, on applique une couche de ce mélange sur un substrat en verre à l'aide d'un-pinceau souple, par exemple. Le mélange peut tout aussi bien être étalé avec une machine à rideaux.

L'épaisseur moyenne de cette couche est fonction de l'application demandée. Elle variera de 5 à 100 µm après séchage.

On insole alors certaines parties de la couche ainsi obtenue à l'aide d'un laser U.V. d'une puissance surfacique d'environ 80 W/cm² dont le faisceau est dévié point par point par un miroir de manière à reproduire l'image visible que l'on souhaite obtenir.

La dimension du faisceau laser est telle que la taille minimale du point élémentaire insolé est de l'ordre de 10 µm.

Le dépouillement des plages non insolées est réalisé par un lavage à l'eau tiède à une température de l'ordre de 50°C. Les rejets sont ensuite récupérés directement et traités par centrifugation.

Enfin on soumet le substrat ainsi revêtu à un cycle de traitement thermique. Celui-ci se décompose en un brûlage de la résine à 430°C pendant 1 heure puis en une cuisson de l'émail et une trempe du substrat en verre aux alentours de 620°C.

Le substrat ainsi obtenu comporte une zone émaillée qui reproduit une image monochrome visible de très haute définition, dont la résolution est égale à 150 D.p.i. Cette excellente résolution est directement liée à la capacité de concentration du faisceau laser, et notamment de l'ordre de 10 µm.

En outre, on a étalonné, dans cette zone émaillée, de manière arbitraire les niveaux de gris de 0 à 21 pour chacun desquels on a mesuré le coefficient de transmission lumineuse. Les valeurs sont regroupées dans le tableau ci-dessous :

**TABLEAU**

| Niveau de gris | Coefficient de transmission lumineuse |
|---|---|
| 1 | 87,1 |
| 2 | 56,2 |
| 3 | 38,0 |
| 4 | 26,3 |
| 5 | 17,8 |
| 6 | 12,6 |
| 7 | 8,9 |
| 8 | 5,9 |
| 9 | 4,3 |
| 10 | 2,9 |
| 11 | 2,1 |
| 12 | 1,5 |
| 13 | 1,1 |
| 14 | 0,7 |
| 15 | 0,5 |
| 16 | 0,40 |
| 17 | 0,28 |
| 18 | 0,22 |
| 19 | 0,15 |
| 20 | 0,10 |
| 21 | 0,07 |

De ce tableau, il ressort clairement que l'opacité de l'image peut être réglée dans une large gamme et donc qu'il est possible d'obtenir des contrastes très prononcés.

Il va de soi que de nombreuses modifications de détail peuvent être apportées au procédé décrit ci-dessus sans pour autant sortir du cadre de l'invention.

Par exemple, il est possible de moduler la dévitrification de la fritte de verre de manière à obtenir une image en couleur sans avoir à utiliser des pigments.

## Revendications

1. Procédé d'obtention d'un motif sur un substrat en matériau verrier **caractérisé en ce qu'**on réalise les étapes suivantes :
a) on dépose sur au moins une zone d'une des faces du substrat une composition à base de particules minérales comportant au moins une fritte de verre et une résine thermo et/ou photosensible comportant au moins un composé photosensible essentiellement constitué d'un polymère réticulable ;
b) on chauffe et/ou on insole certaines plages de manière à faire réticuler le polymère ;
c) on dépouille les plages non chauffées et/ou non insolées ;
d) on soumet ledit substrat à au moins un cycle de traitement, notamment pour permettre la fixation desdites particules minérales.

2. Procédé selon la revendication 1, **caractérisé on ce que** le traitement du substrat selon l'étape d) est un traitement thermique ou aux ultraviolets.

3. Procédé selon la revendication 1 ou 2, **caractérisé en ce que** le dépôt selon l'étape a) est réalisé sous la forme d'une première couche de composition à base de particules minérales revêtue d'une seconde couche de la résine thermo et/ou photosensible.

4. Procédé selon la revendication 1 ou 2, **caractérisé en ce que** le dépôt selon l'étape a) est réalisé sous la forme d'une unique couche de composition à base de particules minérales et la résine thermo et/ou photosensible préalablement mélangées.

5. Procédé selon l'une quelconque des revendications précédentes, **caractérisé en ce que** le polymère réticulable est fabriqué à partir d'acrylate et de dipropylène glycol diacrylate.

6. Procédé selon l'une quelconque des revendications précédentes, **caractérisé on ce que** la résine photosensible comporte au moins un agent sensibilisateur, de préférence moins de 10 % en poids.

7. Procédé selon l'une quelconque des revendications précédentes, **caractérisé en ce que** lorsque la résine utilisée est exclusivement photosensible, on réalise l'étape b) soit à l'aide d'une source de rayonnement, notamment ultraviolet, éclairant toute la surface d'un cliché reproduisant le motif décoratif, soit à l'aide d'une source de rayonnement ponctuelle, notamment ultraviolet, de préférence un laser, dont le faisceau balaie lesdites plages, soit par projection d'une image.

8. Procédé selon l'une quelconque des revendications précédentes, **caractérisé en ce qu'**on choisit une granulométrie moyenne des particules minérales telle que leur diamètre est au plus égal à la dimension des points élémentaires à insoler, de préférence inférieure au dixième.

9. Procédé selon la revendication 8, **caractérisé en ce que** le diamètre desdites particules minérales d₉₀ est inférieur ou égal à 10 µm, de préférence inférieur à 5 µm.

10. Procédé selon l'une quelconque des revendications précédentes, **caractérisé en ce que** selon l'étape d) on soumet le substrat à un cycle de traitement thermique de fixation des particules minérales, à des températures supérieures ou égales aux températures de fusion d'au moins une partie des particules minérales, notamment comprises entre 300°C et 950°C, de préférence égales à 620°C.

11. Procédé selon la revendication 10, **caractérisé en ce que** le cycle de traitement thermique de fixation des particules minérales fait partie d'un cycle de trempe, recuit ou bombage dudit substrat.

12. Procédé selon la revendication 10 ou 11, **caractérisé en ce que**, préalablement au cycle de traitement thermique de fixation des particules minérales, on soumet le substrat à un cycle de traitement thermique de manière à brûler ladite résine photosensible, de préférence à une température de l'ordre de 430°C pendant un temps maximal de 60 minutes par µm d'épaisseur de ladite première couche.

13. Procédé selon l'une quelconque des revendications précédentes, **caractérisé en ce que** la composition à base de particules minérales comprend en outre une poudre métallique et/ou une poudre céramique et/ou une poudre à base d'oxydes métalliques et/ou des particules fonctionnelles du type pigments phosphorescents ou luminescents.

14. Procédé selon l'une quelconque des revendications précédentes, **caractérisé en ce que** la composition à base de particules minérales comprend également des pigments, de préférence d'une seule teinte.

15. Procédé selon ta revendication 14, **caractérisé en ce qu'**on choisit une granulométrie des pigments sensiblement égale à celle des particules de la fritte de verre.

16. Procédé selon la revendication 14 ou 15, **caractérisé en ce que** le diamètre d₉₀ des pigments est inférieur à 10 µm, de préférence compris entre 1 et 5 µm.

17. Procédé selon l'une quelconque des revendications 14 à 16, **caractérisé en ce qu'**on ajoute des pigments dans des proportions telles que le rapport en poids entre la fritte de verre et les pigments est compris entre 50/50 et 90/10, de préférence entre 70/30 et 60/40, pour 100 parties de mélange fritte et pigments.

18. Procédé selon l'une des revendications 14 à 17, **caractérisé en ce que** les pigments sont des pigments de mica.

19. Procédé selon l'une des revendications 14 à 18, **caractérisé en ce qu'**on réalise successivement n fois les étapes a) b) c) sur la même zone, en déposant la même résine **et en ce que** chacune des n compositions comporte majoritairement des pigments de noir, de blanc ou d'une couleur.

20. Procédé selon la revendication 19, **caractérisé en ce que** lorsque n est égal à 4, les quatre compositions comportent majoritairement ensemble des pigments de noir ou blanc et conférant les trois couleurs fondamentales ou complémentaires **et en ce que** chacune d'entre elles comporte majoritairement des pigments de noir ou blanc ou conférant une seule des trois couleurs fondamentales.

21. Substrat obtenu par la mise en oeuvre du procédé selon l'une des revendications 1 à 20.

22. Substrat selon la revendication 21, **caractérisé en ce que** la couleur dudit motif décoratif est monochrome ou polychrome, notamment quadrichrome.

23. Utilisation du substrat selon l'une des revendications 21 ou 22 en tant que verre décoratif à haute résolution.

24. Application du procédé selon l'une quelconque des revendications 1 à 20 à la fabrication de vitrages décoratifs tels qu'une enseigne lumineuse vitrée, une porte de four vitrée avec un bandeau de cuisinière, une vitrine, un vitrail.

25. Application du procédé selon l'une quelconque des revendications 1 à 13 à la fabrication de " faces avant " d'écrans émissifs du type écrans plats tels que des écrans plasma.
